# EUROPÄISCHE PATENTSCHRIFT

(11) **EP 3 395 131 B1**
(45) Veröffentlichungstag und Bekanntmachung des Hinweises auf die Patenterteilung: **05.02.2020**
(21) Anmeldenummer: 16805120.9
(22) Anmeldetag: 01.12.2016
(51) Int. Cl.: H05K 7/14, G01D 11/24, G01P 1/02, H01H 9/04, H02K 5/136, F21V 25/12, H02B 1/28, H02G 3/08, H05K 5/06

(54) **GEHÄUSE FÜR EIN FELDGERÄT**
HOUSING FOR A FIELD DEVICE
BOÎTIER POUR UN APPAREIL DE TERRAIN

(30) Priorität: 21.12.2015 DE 102015122468
(43) Veröffentlichungstag der Anmeldung: 31.10.2018
(73) Patentinhaber: Endress+Hauser Flowtec AG, 4153 Reinach (CH)
(72) Erfinder: FINK, Nikolai, 4147 Aesch (CH); MOSER, Thierry, 68510 Sierentz (FR); LARSSON, Björn, 4127 Birsfelden (CH)
(74) Vertreter: Andres, Angelika Maria
(86) Internationale Anmeldenummer: PCT/EP2016/079471
(87) Internationale Veröffentlichungsnummer: WO 2017/108367

(56) Entgegenhaltungen:
- EP-A2- 1 858 312
- WO-A1-2013/188141
- WO-A2-98/57186
- WO-A2-2011/134770
- DE-A1-102012 005 637
- DE-A1-102012 005 638

## Beschreibung

Die Erfindung betrifft ein Gehäuse eines Feldgeräts der Mess- und Automatisierungstechnik mit einem Gehäusekörper, welcher mindestens zwei Gehäusekammern aufweist, und wobei das Gehäuse für den Betrieb in explosionsgefährdeten Bereichen zugelassen ist.

Feldgeräte werden unter anderem in Umgebungen eingesetzt, in welchen sich brennbare Gase befinden können. Solche Gase können, insbesondere wenn sie ein Feldgerät dauerhaft umgeben in das Gehäuse des Feldgeräts eindringen. Brennbare Gase in Kontakt mit elektronischen Bauteilen stellen ein Sicherheitsrisiko dar, da durch elektronische Bauteile ausgelöste Funkenschläge schwierig zu vermeiden sind. Gehäuse von Feldgeräten sind häufig in mehrere Kammern unterteilt, wobei elektronische Bauteile oder Baugruppen auf diese Kammern verteilt werden. Elektronische Baugruppen verschiedener Kammern müssen jedoch häufig miteinander kommunizieren, so dass elektrische Signale zwischen verschiedenen Kammern ausgetauscht werden müssen. Daher müssen in den Wandungen der Gehäusekammern Öffnungen zur Durchführung von elektrischen Signalen eingerichtet sein, womit eine Explosion in einer Kammer prinzipiell auf eine andere Kammer übergreifen kann. Der Stand der Technik begegnet diesem Problem unter anderem durch Kabeleinführungen oder vergossene Kabelstränge, welche eine Verbindung der elektronischen Bauteile zwischen den Kammern herstellen. Beide Lösungen haben den Nachteil, dass die Anzahl der Leitungen und der damit möglichen Verbindungen begrenzt ist. Eine in dieser Hinsicht bessere Lösung ist der Einsatz vergossener Leiterplatten, da Leiterplatten eine Vielzahl elektrischer Verbindungen aufweisen können. Außerdem kann eine Leiterplatte so bestückt werden, dass ein erster Teil der Bestückung in einer ersten Gehäusekammer und ein zweiter Teil der Bestückung in einer zweiten Gehäusekammer ist. Der Stand der Technik, offenbart durch die Dokumente DE102012005637A1 und DE102012005638B4, führt Kontaktierungselemente durch Öffnungen, um sie nach der Durchführung zu vergießen. Des Weiteren kann das Kontaktierungselement nach DE102012005637A1 stopfenförmig ausgebildet sein. Damit würde im Fall einer Explosion der Explosionsdruck zumindest in einer Richtung dafür sorgen dass das Kontaktierungselement in die Vergussmasse gepresst wird und an seiner vorgesehenen Stelle bleibt. Damit ist das Kontaktierungselement jedoch nur in einer Richtung drucktragend, wodurch für die andere Gehäusekammer eine andere Schutzart zur Vermeidung von Explosionen notwendig wird. Das Einrichten von verschiedenen Schutzarten ist jedoch mit erhöhtem Aufwand verbunden.

Die WO9857186A2 zeigt ein Zweikammergehäuse eines Messgeräts, wobei die Kammern mittels einer Öffnung verbunden sind, welche Öffnung vergossen ist.

Die EP1858312A2 zeigt eine elektronische Baueinheit mit einer Leiterplatte.

Aufgabe der vorliegenden Erfindung ist es daher, ein Gehäuse für ein Feldgerät vorzuschlagen, in welchem die Sicherheit des Feldgeräts durch Erfüllen des Ex-d-Standards in beiden Gehäusekammern unabhängig erfüllt ist, und wobei eine elektrische Verbindung zwischen den Gehäusekammern mittels einer durchgeführten Leiterplatte hergestellt ist. Die Aufgabe wird erfindungsgemäß gelöst durch eine Vorrichtung gemäß dem unabhängigen Anspruch 1.

Das erfindungsgemäße Gehäuse für ein Feldgerät der Mess- und Automatisierungstechnik umfasst mindestens einen Gehäusekörper mit mindestens zwei Gehäusekammern; und mindestens eine Wandung, wobei die Gehäusekammern durch die Wandung getrennt sind, welche Wandung mindestens eine Öffnung aufweist, welche Öffnung die Gehäusekammern miteinander verbindet, wobei die Öffnung dazu eingerichtet ist, mindestens eine Leiterplatte aufzunehmen, welche Leiterplatte sich durch die Öffnung erstreckt, wobei die Leiterplatte durch mindestens eine Halterung gehalten ist, wobei die Öffnung durch eine Vergussmasse geschlossen ist, wobei die Vergussmasse Ex-d-Dichtheit nach der Norm IEC 60079-1 des Jahres 2014 gewährleistet. In einer Ausgestaltung des Gehäuses ist eine Relativbewegung der Leiterplatte bezüglich des Gehäusekörpers behindert.

In einer Ausgestaltung des Gehäuses ist die mindestens eine Halterung auf der Leiterplatte und/oder am Gehäuse fixiert. Die Fixierung kann dabei durch Verkleben oder Verschrauben gegeben sein. Weiterhin kann die Fixierung der Halterung vor oder nach Einschieben der Leiterplatte in die Öffnung durchgeführt werden.

In einer Ausgestaltung des Gehäuses ist die Leiterplatte durch mindestens zwei Halterungen gehalten, wobei die Leiterplatte an einer ersten und einer gegenüberliegenden zweiten Plattenfläche der Leiterplatte durch jeweils mindestens eine Halterung gehalten ist.

In einer Ausgestaltung des Gehäuses ist mindestens eine der zur ersten Plattenfläche gehörenden Halterung gegenüberliegend zu einer zur zweiten Plattenfläche gehörenden Halterung angeordnet. Dadurch wird insbesondere verhindert, dass durch die auf beiden Seiten befindlichen Halterungen Biegekräfte auf die Leiterplatte wirken.

In einer Ausgestaltung des Gehäuses bildet die Wandung einen Anschlag für mindestens eine Halterung bezüglich einer Bewegung der Leiterplatte mit der Halterung in Richtung der Normalen der Öffnung. Im Falle einer Auslenkung der Leiterplatte durch eine Explosion in einer Gehäusekammer kann die Halterung durch Beaufschlagen des Anschlags die Vergussmasse bei der Aufnahme des Explosionsdrucks entlasten.

In einer Ausgestaltung des Gehäuses bildet die Wandung einen Anschlag für jeweils mindestens eine Halterung der ersten Plattenfläche und der zweiten Plattenfläche bezüglich einer Bewegung der Leiterplatte mit der Halterung in Richtung der Normalen der Öffnung. Im Falle einer Auslenkung der Leiterplatte durch eine Explosion in einer Gehäusekammer können die Halterungen durch Beaufschlagen der Anschläge die Vergussmasse bei der Aufnahme des Explosionsdrucks entlasten.

In einer Ausgestaltung des Gehäuses ist die Halterung zumindest teilweise von der Vergussmasse umgeben. Die Bedeckung der Halterung durch die Vergussmasse muss gewährleisten, dass der Kontakt der Halterung mit der Vergussmasse die durch eine Explosion hervorgerufenen Kräfte aufnehmen kann.
In einer Ausgestaltung des Gehäuses ist die Öffnung dazu eingerichtet, einen bestückten Leiterplattenabschnitt aufzunehmen, welcher Leiterplattenabschnitt sich durch die Öffnung erstreckt. Dadurch besteht die Möglichkeit, auf der Leiterplatte elektronische Bauteile oder elektromechanische Verbindungselemente in beiden Gehäusekammern anzuordnen. Die Möglichkeit der Bestückung der Leiterplatte vor Einführen der Leiterplatte in die Öffnung vereinfacht den Zusammenbau des Feldgeräts.

In einer Ausgestaltung des Gehäuses ist die Öffnung dazu eingerichtet ist, einen unbestückten Leiterplattenabschnitt aufzunehmen, welcher Leiterplattenabschnitt sich durch die Öffnung erstreckt.

Im Folgenden wird die erfindungsgemäße Vorrichtung anhand von Ausführungsbeispielen erläutert.

Es zeigt:
Fig. 1: einen beispielhaften Querschnitt durch einen Gehäusekörper;
Fig. 2: einen beispielhaften Querschnitt durch eine Wandung mit Öffnung des Gehäusekörpers, wobei die Öffnung des Weiteren eine mit elektronischen Bauteilen bestückte Leiterplatte aufweist;
Fig. 3: eine Aufsicht auf den in Fig. 2 gezeigten Querschnitt aus der in Fig. 2 definierten Richtung B.

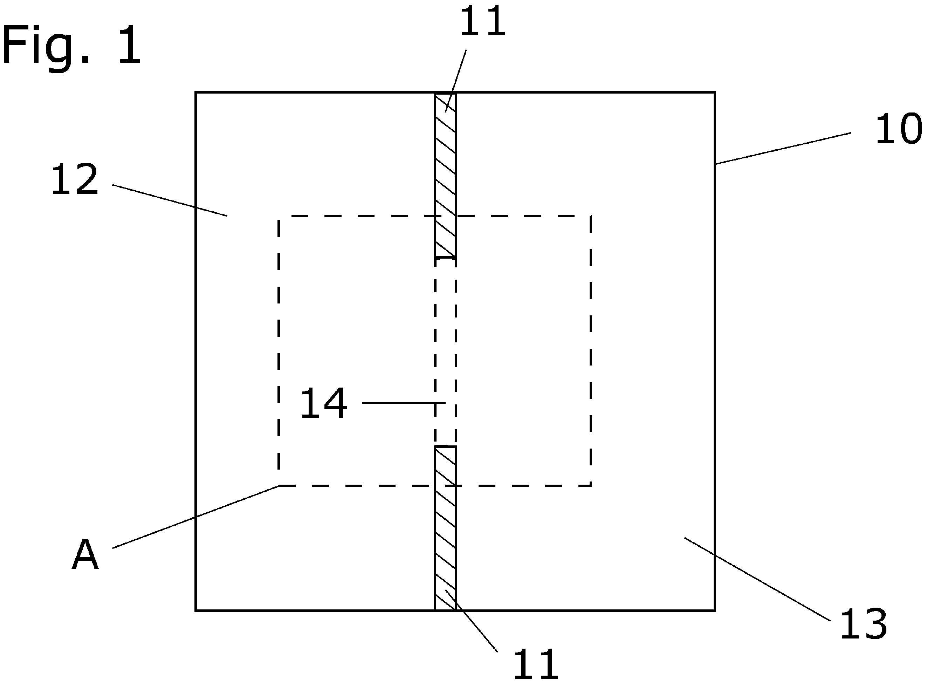

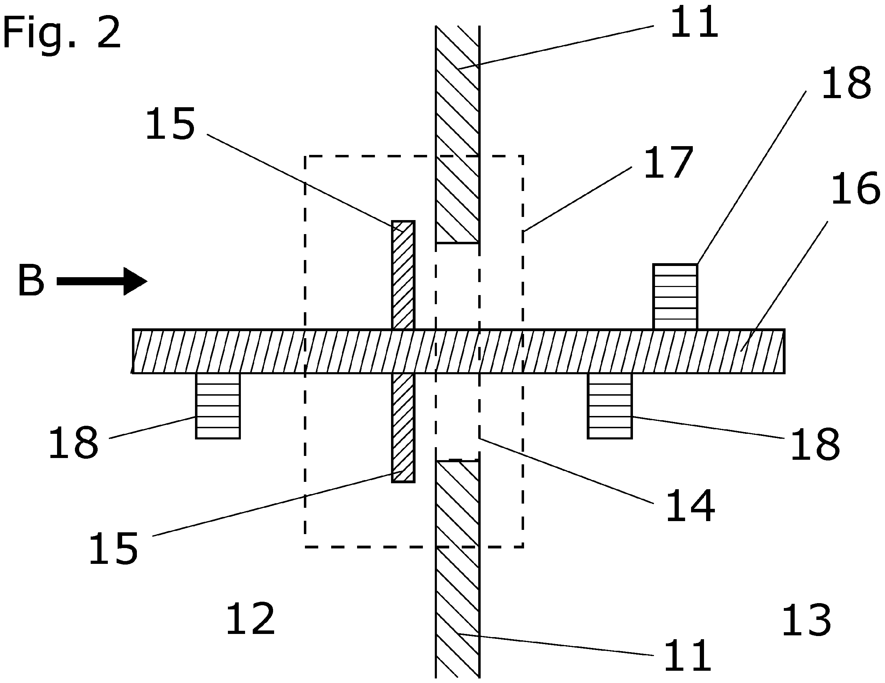

Fig. 1 zeigt einen Querschnitt durch eine Gehäusekammer 10 mit einer Wandung 11, einer ersten Gehäusekammer 12, einer zweiten Gehäusekammer 13 und einer Öffnung 14 der Wandung 11, welche die beiden Gehäusekammern 12, 13 miteinander verbindet. Der Bereich A mit der Öffnung 14 ist in Fig. 2 mit einer Leiterplatte 16 genauer dargestellt.

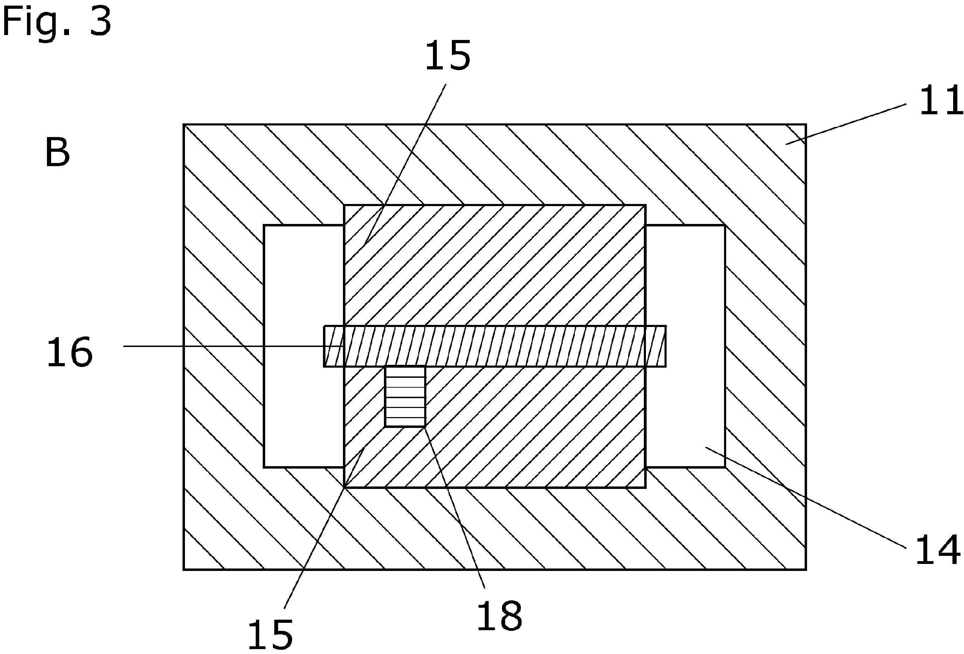

Fig. 2 zeigt den Bereich A, welcher die Öffnung 14 mit einer Leiterplatte 16 umfasst. An der Leiterplatte sind zwei Halterungen 15 angebracht. Die Leiterplatte kann mit elektronischen Bauteilen 18 bestückt sein. Die Vergussmasse wird üblicherweise innerhalb eines Bereichs 17 angewandt, wobei sichergestellt sein muss, dass die Öffnung 14 nach den Anforderungen der druckfesten Kapselung verschlossen ist. Die Vergussmasse umschliesst die Halterungen 15 teilweise oder komplett. Es muss sichergestellt sein, dass die Halterungen 15 über die Kontaktfläche Vergussmasse - Halterung Druckkräfte einer Explosion vollständig aufnehmen können. Die Halterungen sind dabei mindestens 60% und bevorzugt mindestens 75% und insbesondere mindestens 90% durch die Vergussmasse bedeckt. Die Richtung B gibt die Richtung der Aufsicht in Fig. 3 und die Einschubrichtung der Leiterplatte in die Öffnung an. Die Halterungen können dabei vor oder nach Einschieben der Leiterplatte 16 angebracht werden. Die Halterungen können weiterhin so dimensioniert sein, dass sie bei Bewegung in Richtung B durch die Öffnung 17 an der Wandung 11 einen Anschlag finden.
Fig. 3 zeigt eine Aufsicht auf den in Fig. 2 gezeigten Querschnitt, wobei die Wandung 11 die Öffnung 14 aufweist, welche eine mit elektronischen Bausteinen 18 bestückte Leiterplatte 16 aufgenommen hat.

### Bezugszeichenliste

10 Gehäusekörper
11 Wandung
12 erste Gehäusekammer
13 zweite Gehäusekammer
14 Öffnung
15 Halterung
16 Leiterplatte
17 Bereich der Vergussmassenanwendung
18 elektronisches Bauteil
A in Fig. 2 dargestellter Ausschnitt
B Aufsichtsrichtung in Fig. 3, Einschubrichtung der Leiterplatte

## Patentansprüche

1. Gehäuse für ein Feldgerät der Mess- und Automatisierungstechnik umfassend: mindestens einen Gehäusekörper (10) mit mindestens zwei Gehäusekammern (12, 13); und mindestens eine Wandung (11), wobei die Gehäusekammern durch die Wandung getrennt sind, welche Wandung mindestens eine Öffnung (14) aufweist, welche Öffnung die Gehäusekammern (12, 13) miteinander verbindet,
wobei
wobei die Öffnung (14) durch eine Vergussmasse geschlossen ist, wobei die Vergussmasse Ex-d-Dichtheit nach der Norm IEC 60079-1 der Jahres 2014 gewährleistet,
**dadurch gekennzeichnet, dass**
sich mindestens eine Leiterplatte sich durch die Öffnung (14) erstreckt, wobei die Leiterplatte (16) durch mindestens eine Halterung (15) gehalten ist.

2. Gehäuse nach Anspruch 1,
wobei eine Relativbewegung der Leiterplatte (16) bezüglich des Gehäuses (10) mittels der Vergussmasse behindert ist.

3. Gehäuse nach Anspruch 1 oder 2,
wobei die mindestens eine Halterung (15) auf der Leiterplatte und/oder am Gehäusekörper (10) und/oder an der Wandung (11) fixiert ist.

4. Gehäuse nach mindestens einem der vorigen Ansprüche,
wobei die Leiterplatte (16) durch mindestens zwei Halterungen (15) gehalten ist,
wobei die Leiterplatte an einer ersten und einer zweiten Plattenfläche der Leiterplatte (16) durch jeweils mindestens eine Halterung (15) gehalten ist.

5. Gehäuse nach Anspruch 4,
wobei mindestens eine der zur ersten Plattenfläche gehörenden Halterung (15) gegenüberliegend zu einer zur zweiten Plattenfläche gehörenden Halterung angeordnet ist.

6. Gehäuse nach mindestens einem der vorigen Ansprüche,
wobei die Wandung (11) einen Anschlag für mindestens eine Halterung bezüglich einer Bewegung der Leiterplatte (16) mit der Halterung (15) in Richtung der Normalen der Öffnung bildet.

7. Gehäuse nach mindestens einem der vorigen Ansprüche 4 bis 6,
wobei die Wandung (11) einen Anschlag für jeweils mindestens eine Halterung (15) der ersten Plattenfläche und der zweiten Plattenfläche bezüglich einer Bewegung der Leiterplatte (16) mit der Halterung (15) in Richtung der Normalen der Öffnung bildet.

8. Gehäuse nach mindestens einem der vorigen Ansprüche,
wobei die Halterung (15) zumindest teilweise von der Vergussmasse umgeben ist.

9. Gehäuse nach mindestens einem der vorigen Ansprüche,
wobei die Öffnung (14) dazu eingerichtet ist, einen mit elektronischen Bauteilen oder Baugruppen (18) bestückten Leiterplattenabschnitt aufzunehmen, welcher Leiterplattenabschnitt sich durch die Öffnung (14) erstreckt.

10. Gehäuse nach mindestens einem der vorigen Ansprüche 1 bis 8,
wobei die Öffnung dazu eingerichtet ist, einen unbestückten Leiterplattenabschnitt aufzunehmen, welcher Leiterplattenabschnitt sich durch die Öffnung (14) erstreckt.

## Claims

1. Housing for a field device used in measuring and automation technology, comprising:
at least a housing body (10) with at least two housing chambers (12, 13) and at least one wall (11), wherein the housing chambers are separated by the wall, said wall having at least one opening (14), wherein said opening connects the housing chambers (12, 13) with one another,
wherein the opening (14) is closed by a potting compound, wherein said potting compound guarantees Ex-d sealing according to IEC 60079-1 standard from the year 2014,
**characterized in that**
at least one printed circuit board extends through the opening (14),
wherein the printed circuit board (16) is held in place by at least one holder (15).

2. Housing as claimed in Claim 1,
wherein a relative movement of the printed circuit board (16) in relation to the housing (10) is prevented by the potting compound.

3. Housing as claimed in Claim 1 or 2,
wherein at least one holder (15) is fixed on the printed circuit board and/or on the housing body (10) and/or on the wall (11).

4. Housing as claimed in at least of the previous claims,
wherein the printed circuit board (16) is held by at least two holders (15), wherein the printed circuit board is held by at least one holder (15) in each case on a first and on a second surface of the printed circuit board (16).

5. Housing as claimed in Claim 4,
wherein at least a holder (15) pertaining to the first board surface is arranged opposite a holder pertaining to the second board surface.

6. Housing as claimed in at least one of the previous claims,
wherein the wall (11) forms an end stop for at least one holder with regard to a movement of the printed circuit board (16) with the holder (15) in the direction of the normal of the opening.

7. Housing as claimed in at least one of the previous Claims 4 to 6,
wherein the wall (11)) forms an end stop for at least one holder (15) of the first board surface and one holder of the second board surface with regard to a movement of the printed circuit board (16) with the holder (15) in the direction of the normal of the opening.

8. Housing as claimed in at least one of the previous claims,
wherein the holder (15) is surrounded at least partially by the potting compound.

9. Housing as claimed in at least one of the previous claims,
wherein the opening (14) is designed to receive a section of the printed circuit board fitted with electronic components or assemblies (18), said section extending through the opening (14).

10. Housing as claimed in at least one of the previous Claims 1 to 8,
wherein the opening is designed to receive a section of the printed circuit board that is not fitted with components, said section of the printed circuit board extending through the opening (14).

## Revendications

1. Boîtier destiné à un appareil de terrain de la technique de mesure et d'automatisation, comprenant :
au moins un corps de boîtier (10) avec au moins deux chambres de boîtier (12, 13) et au moins une paroi (11), les chambres de boîtier étant séparées par la paroi, laquelle paroi présente au moins une ouverture (14), laquelle ouverture relie entre elles les chambres de boîtier (12, 13),
boîtier pour lequel l'ouverture (14) est fermée par un composé d'enrobage, le composé d'enrobage garantissant l'étanchéité Ex-d selon la norme IEC 60079-1 de 2014,
**caractérisé**
**en ce qu'**au moins une carte de circuit imprimé s'étend à travers l'ouverture (14),
la carte de circuit imprimé (16) étant maintenue par au moins un support (15).

2. Boîtier selon la revendication 1,
pour lequel un mouvement relatif de la carte de circuit imprimé (16) par rapport au boîtier (10) est empêché au moyen du composé d'enrobage.

3. Boîtier selon la revendication 1 ou 2,
pour lequel l'au moins un support (15) est fixé sur la carte de circuit imprimé et/ou sur le corps de boîtier (10) et/ou sur la paroi (11).

4. Boîtier selon au moins l'une des revendications précédentes,
pour lequel la carte de circuit imprimé (16) est maintenue par au moins deux supports (15), la carte de circuit imprimé étant maintenue sur une première et une deuxième surface de la carte de circuit imprimé (16) par respectivement au moins un support (15).

5. Boîtier selon la revendication 4,
pour lequel au moins l'un des supports (15) appartenant à la première surface de carte est disposé à l'opposé d'un support appartenant à la deuxième surface de carte.

6. Boîtier selon au moins l'une des revendications précédentes,
pour lequel la paroi (11) fait office de butée pour au moins un support par rapport à un mouvement de la carte de circuit imprimé (16) avec le support (15) en direction de la normale de l'ouverture.

7. Boîtier selon au moins l'une des revendications précédentes 4 à 6,
pour lequel la paroi (11)) fait office de butée pour respectivement au moins un support (15) de la première et de la deuxième surface de carte par rapport à un mouvement de la carte de circuit imprimé (16) avec le support (15) en direction de la normale de l'ouverture.

8. Boîtier selon au moins l'une des revendications précédentes,
pour lequel le support (15) est entouré au moins partiellement de composé d'enrobage.

9. Boîtier selon au moins l'une des revendications précédentes,
pour lequel l'ouverture (14) est conçue de telle sorte à recevoir une section de plaque de circuit imprimé équipée de pièces ou de composants (18), laquelle section de plaque de circuit imprimé s'étend à travers l'ouverture (14).

10. Boîtier selon au moins l'une des revendications précédentes 1 à 8,
pour lequel l'ouverture est réalisée de telle sorte à recevoir une section de carte de circuit imprimé non équipée de composants, laquelle section de carte de circuit imprimé s'étend à travers l'ouverture (14).
